# EUROPÄISCHE PATENTSCHRIFT

(11) **EP 3 665 315 B1**
(45) Veröffentlichungstag und Bekanntmachung des Hinweises auf die Patenterteilung: **27.12.2023**
(21) Anmeldenummer: 18742943.6
(22) Anmeldetag: 02.07.2018
(51) Int. Cl.: C23C 14/32, C23C 14/06, C23C 14/04, C23C 14/00, H01J 37/32

(54) **ANORDNUNG ZUR BESCHICHTUNG VON SUBSTRATOBERFLÄCHEN MITTELS ELEKTRISCHER LICHTBOGENENTLADUNG**
ARRANGEMENT FOR COATING SUBSTRATE SURFACES BY MEANS OF ELECTRIC ARC DISCHARGE
DISPOSITIF DE REVÊTEMENT DE SURFACES DE SUBSTRATS PAR DÉCHARGE DE TYPE ARC ÉLECTRIQUE

(30) Priorität: 02.08.2017 DE 102017213404
(43) Veröffentlichungstag der Anmeldung: 17.06.2020
(73) Patentinhaber: Fraunhofer-Gesellschaft zur Förderung der angewandten Forschung e.V., 80686 München (DE)
(72) Erfinder: ZIMMER, Otmar, 01157 Dresden (DE); KAULFUSS, Frank, 01157 Dresden (DE)
(74) Vertreter: Pfenning, Meinig & Partner mbB
(86) Internationale Anmeldenummer: PCT/EP2018/067771
(87) Internationale Veröffentlichungsnummer: WO 2019/025098

(56) Entgegenhaltungen:
- EP-A1- 2 123 789
- WO-A1-87/05948
- WO-A1-03/044240
- WO-A1-2008/145459
- WO-A2-2008/128536
- DE-A1- 19 522 331
- US-A- 4 839 011
- US-A- 5 380 421
- US-A1- 2004 016 641
- US-A1- 2005 003 019
- KUMAR VINEET ET AL: "Stabilization of cubic phase in AlTiN coatings using anode configurations", INTERNATIONAL JOURNAL OF REFRACTORY METALS AND HARD MATERIALS, ELSEVIER, AMSTERDAM, NL, Bd. 60, 2. Juli 2016 (2016-07-02), Seiten 113-117, XP029683828, ISSN: 0263-4368, DOI: 10.1016/J.IJRMHM.2016.06.022

## Beschreibung

Die Erfindung betrifft eine Anordnung zur Beschichtung von Substratoberflächen mittels elektrischer Lichtbogenentladung. Es können insbesondere mit Nitrid gebildete Beschichtungen, insbesondere nitridische Beschichtungen auf Oberflächen von Substraten vorteilhaft ausgebildet werden.

Die Vakuumbogentechnologie ist eine Standardtechnologie zur Abscheidung dünner Schichten. Industriell werden damit vorrangig Werkzeuge beschichtet. Typische Schichtsysteme sind nitridische Hartstoffe wie TiN, AlTiN, CrN, AlCrN u.a. Die Beschichtung erfolgt im Vakuum innerhalb einer Kammer. Mit Hilfe einer elektrischen Bogenentladung wird ein zumeist metallischer Werkstoff eines Targets, das als Kathode geschaltet ist, verdampft und der entstehende Dampf wird gleichzeitig ionisiert. Das Plasma kondensiert auf den zu beschichtenden Oberflächen und bildet eine dichte dünne Schicht. Durch Zugabe von Reaktivgasen (z.B. Stickstoff) erfolgt eine chemische Reaktion des Plasmas mit dem Reaktivgas und die Schicht wird durch die Reaktionsprodukte gebildet. So wird z.B. durch Verdampfung eines Targets aus Titan in einer Stickstoffatmosphäre der Hartstoff Titannitrid als Schicht auf einer Oberfläche eines Substrats bzw. Werkstücks hergestellt.

Um besonders dichte, harte Schichten herzustellen, wird an die zu beschichtenden Bauteile eine negative elektrische Vorspannung (Bias) angelegt, wobei die geladenen Beschichtungsteilchen in Richtung der Werkstückoberfläche beschleunigt werden. Die Energie der Beschichtungsteilchen beim Auftreffen ist entscheidend für die Eigenschaften der aufwachsenden Schicht.

Allerdings ist die Wirkung der Bias-Spannung auf Grund der elektrischen Feldverteilung sehr stark von der Oberflächengeometrie der zu beschichtenden Teile abhängig. Stark konvexe Geometrien (Beispiel: Schneidkanten) führen zu starken Überhöhungen des elektrischen Feldes. Die Ionenenergien in diesen Bereichen können extrem hoch werden. Dies kann negative Folgen haben, wie z.B. Materialabtrag mit einhergehender Kantenverrundung sowie Überhitzung.

Andererseits ist in konkaven Bereichen (z.B. in Werkzeugkavitäten) eine Abschwächung oder ein völliges Verschwinden des elektrischen Feldes zu beobachten. Die Ionenenergien der Beschichtungsteilchen sind in diesen Zonen vergleichsweise gering, dies führt ggf. zu nachteiligen Schichteigenschaften (z.B. Porosität).

Gesucht ist daher eine Beschichtungstechnologie, die ein ausreichend hochenergetisches Beschichtungsplasma zur Verfügung stellt, um geometrische komplexe Substrate gleichmäßig und in guter Qualität zu beschichten.

Die gängige Lösung zur Beschichtung geometrisch komplexer Substrate ist die Nutzung der thermischen CVD als Beschichtungstechnologie. Das als Träger des Schichtmaterials genutzte Precursor-Gas kann sich ungehindert allseitig auch in Kavitäten ausbreiten, die für die Schichtbildung ausschlaggebende Temperatur des Werkstücks oder Bauteils ist geometrieunabhängig. Eine elektrische Bias-Spannung wird nicht benötigt. Allerdings ist nur eine geringe Auswahl an Schichtsystemen mit der CVD-Technologie herstellbar. Darüber hinaus ist die thermische Belastung der Substrate extrem hoch (ca. 1000°C).

Dadurch ist die Nutzbarkeit des Verfahrens sehr stark eingeschränkt.

Mit klassischen PVD- Verfahren nach dem Stand der Technik ist dieses Problem nicht befriedigend zu lösen. In einschlägigen Katalogen und Werbeschriften der Beschichtungsdienstleister wird ausdrücklich auf die Schwierigkeiten bei der Beschichtung von tiefen Kavitäten hingewiesen. Gängige Praxis ist ein Kompromiss, bei dem Prozessparameter gewählt werden, die in den relevanten Zonen einigermaßen akzeptable Schichteigenschaften erwarten lassen. Die Beschichtung tiefer Kavitäten wird dabei von vornherein vermieden.

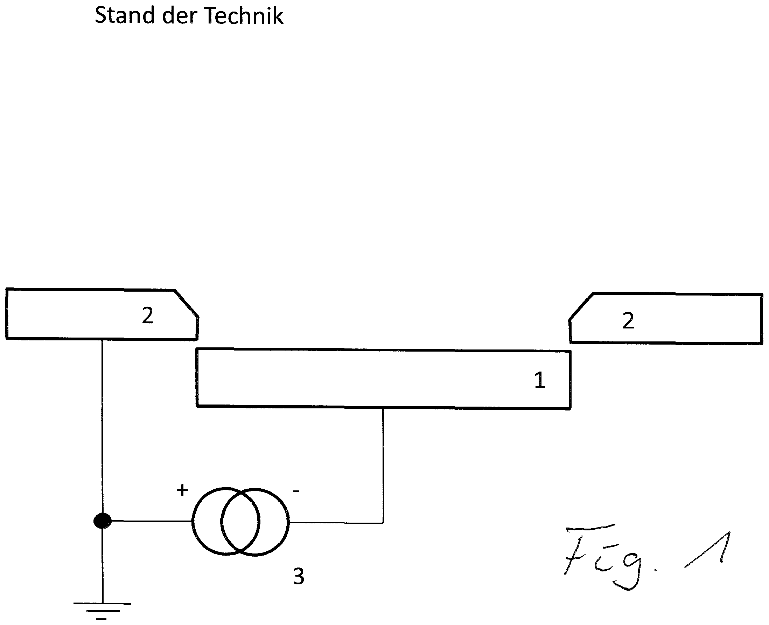

Eine herkömmliche Anordnung für die Ausbildung von Beschichtungen in einer Vakuumkammer mittels elektrischer Bogenentladung ist in Figur 1 gezeigt.

Dabei ist ein elektrisch als Kathode geschaltetes Target 1 an den negativen Pol einer elektrischen Stromquelle 3 angeschlossen. Das Target 1 ist aus einem Metall gebildet, mit dem die Ausbildung einer Beschichtung auf einer Oberfläche eines hier nicht gezeigten Substrats erfolgt. Das Substrat wäre gemäß der Darstellung in Figur 1 oberhalb der vertikal oberen Oberfläche des Targets 1 und oberhalb der in Richtung Substrat weisenden Oberfläche einer Anode 2 angeordnet. Die Anode 2 ist dabei an den anderen, also den positiven Pol der elektrischen Spannungsquelle 3 angeschlossen. Es stellt sich also eine elektrische Spannung zwischen dem Target 1 und der Anode 2 ein, wenn die elektrische Stromquelle 3 eingeschaltet ist. Wie bereits ausgeführt, kann in die Vakuumkammer ein Reaktivgas, wie z.B. Stickstoff bei der Durchführung der Beschichtung eingeführt werden. Dadurch kann eine Beschichtung, die aus einem chemischen Reaktionsprodukt des metallischen Targetwerkstoffs und dem Reaktivgas gebildet ist, ausgebildet werden.

In herkömmlichen Beschichtungsanlagen wird die Anode 2 häufig ergänzt bzw. ersetzt durch die anodisch geschaltete Wand der Vakuumkammer (hier nicht gezeigt).

Lediglich für Sonderanwendungen in der Mikrosystemtechnik (z.B. Füllen von Gräben in Si mit Metall als Leiterbahn) wurde unter Laborbedingungen demonstriert, dass mit hoch ionisierten Plasmen Kavitäten befriedigend beschichtbar sind. Die dabei genutzte Technologie (High-current-pulsed-arc, HCA, eine Arc-PVD-Technologie mit gepulsten Entladungsströmen) ist allerdings sehr aufwändig und für industrielle Werkzeugbeschichtungen nicht geeignet.

So sind in US 2005/0003019 A1 Möglichkeiten der Ausbildung antimikrobioller Schichten auf Substraten mittels elektrischer Bogenentladung beschrieben.

US 4 839 011 A betrifft einen Beschichtungsprozess für legierte Beschichtungen.

Aus US 2004/0016641 A1 ist ein gepulst betriebener Plasmaprozess bekannt.

Aus EP 2 123 789 A1 geht ein Verfahren zum Erhalt harter Schichten hervor.

Es ist Aufgabe der Erfindung, Möglichkeiten für die Ausbildung von homogenen Beschichtungen an Substratoberflächen mit zumindest nahezu konstanter Schichtdicke, reduzierter Porosität und guter Haftung anzugeben.

Erfindungsgemäß wird diese Aufgabe mit einer Anordnung, die mit den Merkmalen des Anspruchs 1 ausgebildet ist, gelöst. Vorteilhafte Ausgestaltungen und Weiterbildungen der Erfindung können mit in untergeordneten Ansprüchen bezeichneten Merkmalen realisiert werden.

Bei der erfindungsgemäßen Anordnung zur Beschichtung von Substratoberflächen mittels elektrischer Lichtbogenentladung in einer Vakuumkammer, werden elektrische Bogenentladungen zwischen einem elektrisch als Kathode geschalteten Target, das aus einem metallischen Werkstoff gebildet ist, und einer in einem Abstand zum Target angeordneten Anode zur Bildung eines mit metallischem Werkstoff des Targets gebildeten Plasmas, gezündet. Das Target ist an eine erste elektrische Stromquelle und die mindestens eine Anode ist an eine zweite elektrische Stromquelle angeschlossen. Dabei unterscheiden sich die absoluten Beträge der an das Target und der an die Anode angeschlossenen elektrischen Spannungen voneinander.

Es sind mehrere Anoden in einem Abstand zueinander und in Richtung auf die jeweilige zu beschichtende Substratoberfläche angeordnet. Sie sollen an jeweils eine eigene elektrische Stromquelle angeschlossen sein, wobei die mehreren Anoden auf jeweils unterschiedliche elektrische Spannungspotentiale gelegt sein. Dabei soll eine Differenz des positiven elektrischen Spannungspotentials zwischen zwei neben einander angeordneten Anoden von mindestens 5 V, bevorzugt mindestens 10V eingehalten sein. Die elektrischen Spannungspotentiale an den Anoden sollen sich in Richtung der zu beschichtenden Substratoberfläche erhöhen.

Alle elektrischen Stromquellen sollten gleichzeitig eingeschaltet sein.

Die mindestens eine Anode oder mehrere Anoden sollte(n) ringförmig ausgebildet, und das Target im Inneren des/der Ringe(s) angeordnet sein.

Die in Richtung der zu beschichtenden Substratoberfläche weisende Oberfläche der ersten Anode sollte die in Richtung zur zu beschichtenden Substratoberfläche weisenden Oberfläche des Targets überragen. Der Abstand zwischen den Oberflächen des Targets und der ersten Anode sollte mindestens 5 mm betragen.

Die ringförmig ausgebildete(n) Anode(n) können an ihrer Innenseite konisch ausgebildet sein, so dass sich der Innendurchmesser in Richtung der zu beschichtenden Substratoberfläche konisch erweitert. Dies trifft insbesondere auch auf die Innendurchmesser der übereinander angeordneten ringförmigen Anoden zu, die sich in Richtung der zu beschichtenden Substratoberfläche vergrößern. Diese Vergrößerung kann sukzessive oder kontinuierlich gewählt werden.

Die Anode(n) kann/können aus Graphit gebildet und/oder ihre Innenwand/- wände mit einer bevorzugt aus Graphit gebildeten Abdeckung versehen sein. Die Abdeckungen sollten elektrisch leitend mit der/den Anode(n) verbunden sein.

Zur reaktiven Schichtbildung kann mindestens ein Reaktivgas in die Vakuumkammer eingeführt werden. Dieses Reaktivgas kann mit dem Metall, mit dem das Plasma gebildet ist, chemisch reagieren, so dass die Beschichtung mit dem chemischen Reaktionsprodukt ausgebildet werden kann.

Das Target kann aus einem reinen Metall oder mit einer Legierung bzw. Elementmischung gebildet sein, die bevorzugt ausgewählt ist aus, AlCr, AlTi, AlTiMg, AlTiSi, AlCrSi, AlCrY, AlCrC, CrTiSi, CrSi, CrCu, CrFeNi, CoCrFeMnNi, CoCrFeNi, CoCrFeCu,TiSi, IrPt, NiCr, NiCrCo, NiCrCoTi, NiCrCoTiAl, NbTiVZrMo, und NiV Auf entsprechend damit erhaltbare Beschichtungen wird bei der Beschreibung von Ausführungsbeispielen noch eingegangen werden.

Die bereits erwähnte HCA- Technologie impliziert die Nutzung sehr hoch ionisierter Plasmen zur Beschichtung konkaver Geometrien. Dieser Ansatz wird auch bei der vorliegenden Erfindung genutzt.

Im Gegensatz zur HCA-Technologie, bei der die hohe Ionisierung direkt an der Kathode durch die Nutzung gepulster elektrischer Entladungsströme mit extrem hohen Spitzenstromstärken (mehrere kA) erreicht wird, wird beim vorgeschlagenen Lösungsweg eine klassische elektrische Gleichstrombogenentladung mit moderaten elektrischen Entladungsströmen von einigen zehn bis wenigen hundert Ampere zur Plasmaerzeugung genutzt. Dadurch ist die Übertragbarkeit auf industrielle Anwendungen gesichert.

Allerdings muss hier die erhöhte Ionenenergie auf anderem Wege zur Verfügung gestellt werden. Dies erfolgt erfindungsgemäß durch Einführung eines oder mehrerer zusätzlicher elektrischer Anodenspannungspotenziale für die elektrische Bogenentladung, die ggf. durch Zusatzanoden in den Prozess eingeführt werden. Damit wird es möglich, dem Beschichtungsplasma auch in kathodenfernen Bereichen zusätzlich Energie zuzuführen und damit Anregung und lonisierungszustände zu erhöhen.

In Lichtbogen-Beschichtungsanlagen nach dem Stand der Technik wird als Anode der plasmaproduzierenden elektrischen Bogenentladung typischerweise die komplette Wand der Beschichtungskammer als Anode genutzt. Da diese gewöhnlich aus Metall gefertigt ist, ist dies eine kostengünstige und zuverlässige Variante. Wegen der großen verfügbaren inneren Oberfläche der Vakuumkammer ist diese Lösung auch relativ unempfindlich gegen Verschmutzung, solange keine rein dielektrischen Schichten abgeschieden werden.

Bei der Erfindung wird zu einer ersten Anode mindestens eine zweite Anode mit einem zweiten, abweichenden elektrischen Anodenspannungspotential eingesetzt. Diese kann z.B. in unmittelbarer Kathodennähe, z.B. als Ring um das die Kathode bildende Target ausgeführt werden. Zusätzlich kann eine dritte Anode mit einem dritten elektrischen Anodenspannungspotential verwendet werden, die z.B. an einer anderen Seite der Beschichtungskammer platziert ist, vorzugsweise an einer Stelle, bei der eine erhöhte Plasmaanregung wünschenswert ist. Bei Bedarf können weitere zusätzliche Anoden mit weiteren elektrischen Anodenspannungspotentialen an weiteren Orten in der Beschichtungskammer angeordnet werden. Die Anordnung kann vorteilhaft so erfolgen, dass eine möglichst, hohe und gleichmäßige Plasmaanregung in der Beschichtungszone an der jeweiligen zu beschichtenden Oberfläche aufrechterhalten werden kann. Alternativ kann auch eine gezielt ungleichmäßige, z.B. eine besonders konzentrierte, Plasmaverteilung eingestellt werden.

Die elektrischen Anodenspannungspotenziale der zusätzlichen Anoden können dabei unabhängig voneinander eingestellt werden. Je nach Beschichtungsaufgabe können sie konstant gehalten, während des Prozesses variiert (z.B. zur optimalen Abscheidung mehrlagiger Beschichtungen) oder gepulst angelegt werden.

Die Wirkungen der zusätzlich eingebauten Anode bzw. Anoden inkl. der daran angelegten zusätzlichen elektrischen Anodenspannungspotentiale bestehen einerseits in der zusätzlichen Leistungseinkopplung in das Beschichtungsplasma, insbesondere in die metallische Fraktion des Plasmas. Darüber hinaus ergibt sich eine gezielte Steuerbarkeit der räumlichen Plasmaanregung in der Vakuumkammer. Durch die damit verbundenen erhöhten Energien der Beschichtungsteilchen kann in vielen Fällen die Schichtqualität verbessert bzw. auf die Nutzung einer elektrischen Biasspannung verzichtet oder diese erheblich reduziert werden, ohne Einbußen der Schichtqualität in Kauf nehmen zu müssen. Darüber hinaus wird die Beschichtbarkeit von Oberflächen dielektrischer Werkstoffe, z.B. Keramiken oder Kunststoff verbessert.

Bei den an das Target und die Anode(n) angeschlossenen elektrischen Stromquellen ist es vorteilhaft, dass die elektrischen Spannungspotentiale an Target und Anode(n) jeweils einzeln und unabhängig voneinander gesteuert bzw. eingestellt werden können. Die Einstellung der elektrischen Spannungspotentiale kann wahlweise über die Vorgabe einer festen, konstanten elektrischen Spannung oder alternativ über die Vorgabe eines festen, konstanten elektrischen Stromes erfolgen. Im ersten Fall stellt sich dann prozessabhängig eine elektrische Stromstärke, in zweiten Fall ein elektrischer Spannungswert an der entsprechenden Stromquelle ein.

Die Erfindung kann vorrangig in Anlagen zur Beschichtung von Werkzeugen und Bauteilen mit Metall- oder Hartstoffschichten eingesetzt werden. Besonders sinnvoll ist der Einsatz der Erfindung bei der Beschichtung von Werkzeugen und Bauteilen als Substraten mit ausgeprägter Oberflächentopografie, insbesondere mit konkaven Bereichen (Kavitäten) sowie konvexen Bereichen, z.B. Schneidkanten. Dies betrifft z.B. Werkzeuge zur Ur- oder Umformung, Schneidwerkzeuge oder komplex geformte Maschinenteile, die vor Verschleiß geschützt werden sollen.

Nachfolgend soll die Erfindung beispielhaft näher erläutert werden.

Dabei zeigen:
- Figur 1: in schematischer Form ein Beispiel nach dem Stand der Technik
- Figur 2: in schematischer Form ein Beispiel einer Anordnung, die nicht unter die Erfindung fällt;
- Figur 3: in schematischer Form ein Beispiel einer erfindungsgemäßen Anordnung;
- Figur 4: in schematischer Form ein zweites Beispiel einer erfindungsgemäßen Anordnung;
- Figur 5: in schematischer Form ein drittes Beispiel einer erfindungsgemäßen Anordnung und
- Figur 6: in schematischer Form ein viertes Beispiel einer erfindungsgemäßen Anordnung.

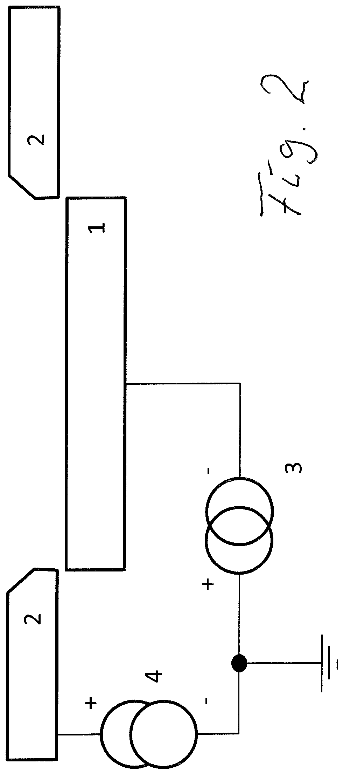

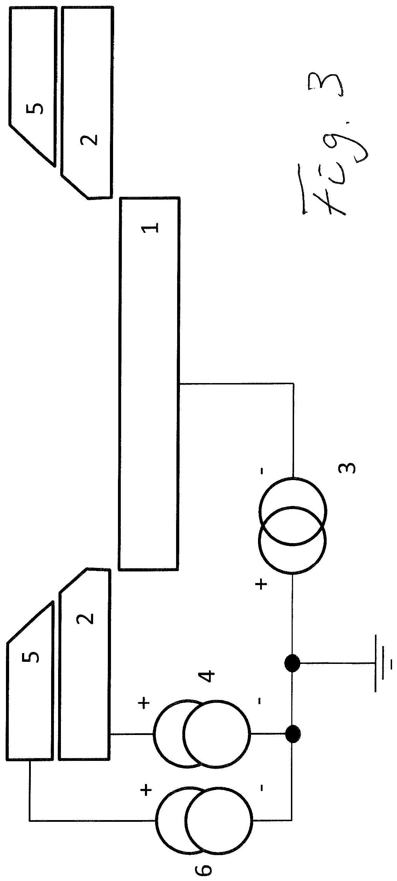

Bei dem in Figur 2 gezeigten Beispiel, wie auch bei den nachfolgend zu den Figuren 3 bis 6 beschriebenen Beispielen ist auf die Darstellung einer zu beschichtenden Substratoberfläche, die eine Oberfläche eines Werkstücks oder Werkzeugs sein kann, verzichtet worden. Das jeweilige Substrat wäre aber in allen Darstellungen vertikal oberhalb der in Richtung Substrat weisenden Oberflächen der jeweiligen Targets und Anoden 2, 5 und 7 angeordnet.

Bei dem Beispiel nach Figur 2 ist eine ringförmige Anode 2 so in Bezug zu einem Target 1, das als plattenförmiges Element aus metallischem Werkstoff gebildet ist, angeordnet, dass seine in Richtung zur Substratoberfläche weisende Oberfläche die entsprechende Oberfläche des Substrates überragt.

Bei diesem Beispiel kann die Anode 2 aus Graphit gebildet sein und ist an eine eigene elektrische Stromquelle 4 angeschlossen. Das Target 1 verfügt über eine eigene elektrische Stromquelle 3, so dass an den beiden elektrischen Stromquellen 3 und 4 jeweils unterschiedliche Beträge der angelegten elektrischen Spannungen eingehalten werden können.

Bei dem in Figur 3 gezeigten Beispiel ist eine zweite Anode 5 in Richtung der zu beschichtenden Substratoberfläche weisenden Seite oberhalb der ersten Anode 2 angeordnet. Die zweite Anode 5 ist an eine eigene elektrische Stromquelle 6 angeschlossen, so jeweils ein unterschiedliches positives elektrisches Spannungspotential an die beiden Anoden 2 und 5 angelegt werden kann, um das mit der elektrischen Lichtbogenentladung gebildete Plasma lokal definiert energetisch zu beeinflussen.

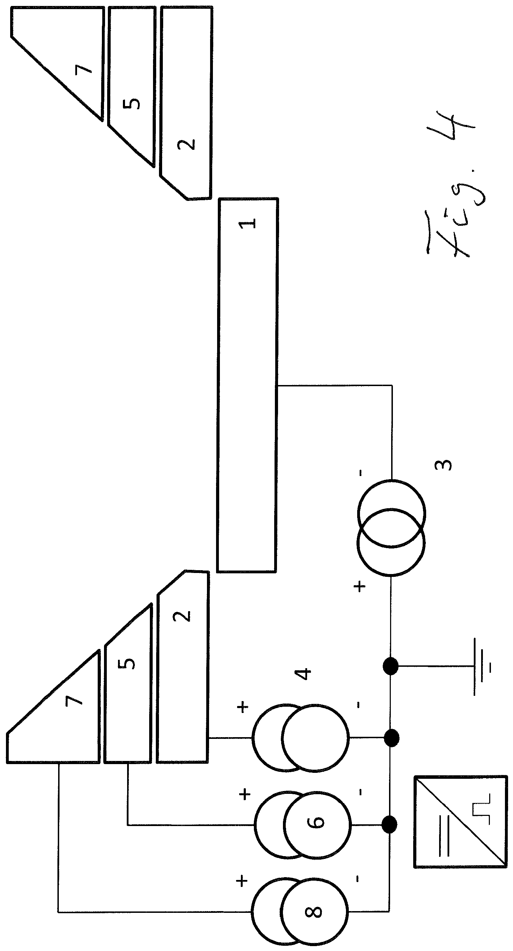

Bei dem in Figur 4 gezeigten Beispiel ist im Unterschied zum Beispiel nach Figur 3 eine dritte Anode 7 in Richtung der zu beschichtenden Substratoberfläche weisenden Seite oberhalb der zweiten Anode 5 angeordnet. Auch diese dritte Anode 7 ist an eine eigene elektrische Stromquelle 8 angeschlossen, so dass auch bei diesem Beispiel jeweils ein unterschiedliches positives elektrisches Spannungspotential an die beiden Anoden 2 und 5 angelegt werden kann.

Bei diesen Beispielen wird deutlich, dass die Innenwand der ringförmigen Anoden 2, 5 und 7 zumindest teilweise konisch ausgebildet sein können. Dabei können sich die Innendurchmesser in Richtung der zu beschichtenden Substratoberfläche vergrößern.

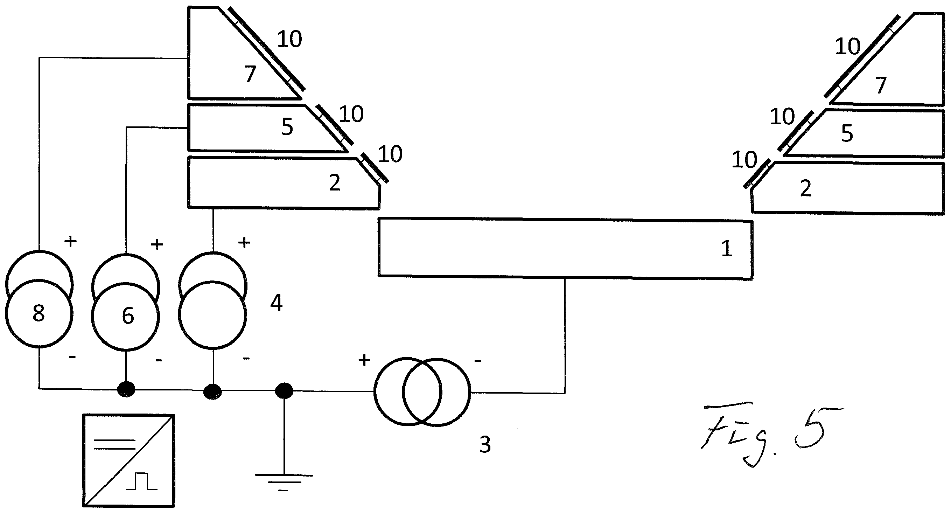

Das In Figur 5 gezeigte Beispiel unterscheidet sich vom Beispiel nach Figur 4 lediglich dadurch, dass an den Innenwänden der ringförmigen Anoden 2, 5 und 7 jeweils eine Abdeckung 10 angeordnet ist. Die Abdeckungen 10 können vorteilhaft aus Graphit bestehen. Dadurch kann man Anoden 2, 5 und 7, die aus Metall gebildet sind, einsetzen.

Solche Abdeckungen können aber auch bei allen anderen hier gezeigten und beschriebenen Beispielen an Anoden vorhanden sein.

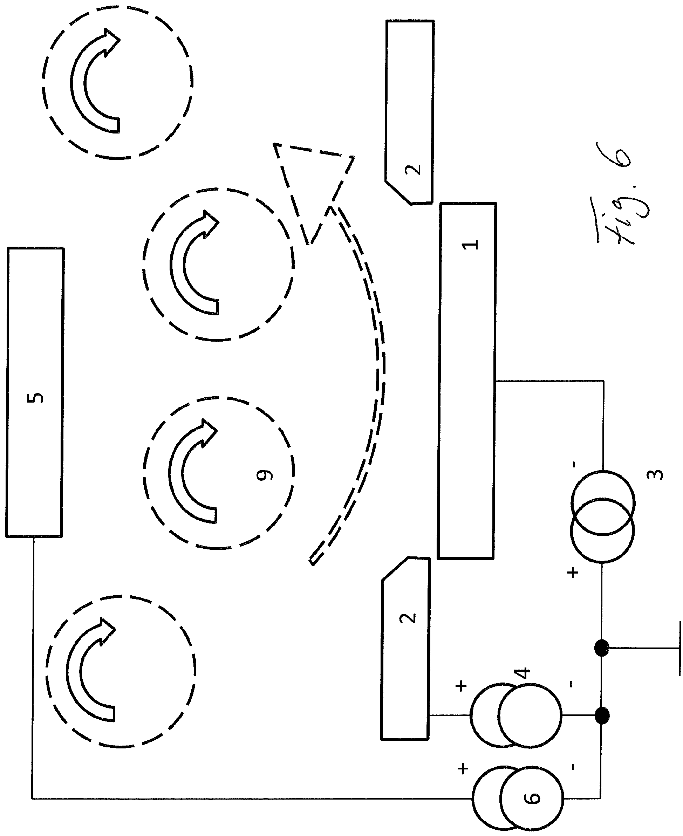

Bei dem in Figur 6 gezeigten Beispiel, das auf das Beispiel nach Figur 2 aufbaut, ist eine zweite Anode 5 als plattenförmiges Element ausgebildet und oberhalb des Targets 1 angeordnet. Die Anode 5 kann dabei unmittelbar zwischen der Oberfläche des Targets 1 auf der der Fußpunkt elektrischer Lichtbögen läuft und der zu beschichtenden Substratoberfläche angeordnet sein. Es ist aber auch in nicht dargestellter Form ein seitlicher Versatz oder der Einsatz mehrerer seitlich versetzt angeordneter Anoden möglich. Es sollte dabei aber gesichert sein, dass die Energie des mit der elektrischen Lichtbogenentladung gebildeten Plasma vorteilhaft lokal definiert beeinflusst wird.

Die Anode 5 kann gekühlt und auch stabförmig ausgebildet sein.

### Beispiel 1 (nicht erfinderisch):

Es liegt eine Anordnung gemäß Figur 2 vor, wobei die Anode 2 zusätzlich mit einer Abdeckung 10 aus Graphit gemäß Figur 5 belegt sein kann.

Es wird ein Prozess durchgeführt, bei dem metallische Substrate mit einer AlTiOₓN_{y} - Schicht beschichtet werden. Zunächst werden die Substrate chemisch gereinigt, getrocknet und in die Vakuumkammer auf Halterungen angeordnet. Nach der Evakuierung auf 10⁻³ Pa erfolgt eine Ionenreinigung mit Argonionen. Die anschließende Beschichtung erfolgt, in dem als Kathode geschaltete Target 1, das eine Platte aus AlTi in der Zusammensetzung (66:33 at%) ist, verwendet wird. Als Reaktivgase wird eine Mischung aus Stickstoff und Sauerstoff im Verhältnis 70:30 Vol.-% bei einem Druck von 1 Pa in die Vakuumkammer zugeführt. Mit einem elektrischen Entladungsstrom von 100 A an der elektrischen Stromquelle 3 und einer elektrischen Spannung am Target 1 wird Targetwerkstoff mit einer elektrischen Bogenentladung sukzessive verdampft. Die elektrische Spannung der Anodenstromquelle 4 wird auf 30 V eingestellt. Es stellt sich dort ein elektrischer Strom von ca. 90 A ein. Die elektrische Bogenentladung wird so lange betrieben, bis die gewünschte Schichtdicke erreicht ist.

Im Ergebnis ist eine AlTiOxNy - Schicht mit einem relativ geringen N- Anteil von ca. 5% auf der Substratoberfläche ausgebildet worden. Die Beschichtung ist beständig gegen Verschleiß und hat einen hohen elektrischen Widerstand.

### Beispiel 2:

Es wird eine Anordnung gemäß Figur 5 eingesetzt. Es wird ein Prozess durchgeführt, bei dem ein Umformwerkzeug mit Einsenkungen (Kavitäten) als Substrat beschichtet werden soll. Die Beschichtung erfolgt mit einer AlCrSiN-Schicht. Zunächst wird das Werkzeug chemisch gereinigt, getrocknet und in der Vakuumkammer so angeordnet, dass das Beschichtungsplasma die Arbeitsflächen des Werkzeugs erreichen kann. Nach der Evakuierung auf 10⁻³ Pa erfolgt eine Ionenreinigung mit Argonionen. Die anschließende Beschichtung erfolgt, in dem das als Kathode geschaltete Target 1, das eine Platte aus AlCrSi in der Zusammensetzung (66:29:5 at%) ist, verwendet wird. Als Reaktivgas wird Stickstoff bei einem Druck von 1 Pa in die Vakuumkammer eingeführt. Mit einem elektrischen Entladungsstrom von 100 A an der Stromquelle 3 wird Targetwerkstoff mit einer elektrischen Bogenentladung sukzessive verdampft. Die elektrische Spannung der Stromquelle 4 für die erste Anode 2 wird auf 5 V eingestellt, die elektrische Spannung an der Stromquelle 6, an die die zweite Anode 5 angeschlossen ist, wird auf 30 V eingestellt. Die Stromquelle 8 für die dritte Anode 7 wird gepulst betrieben. Dabei werden Spannungsimpulse von 100 V mit einer Frequenz von 1 kHz und einer Pulslänge von 500 µs angelegt. Während der Beschichtung wird das zu beschichtende Werkzeug auf einem elektrischen Potential (Bias-Spannung) von - 10 V gegenüber dem Erdpotential gehalten.

Die elektrische Bogenentladung wird so lange betrieben, bis die gewünschte Schichtdicke erreicht ist.

Im Ergebnis ist eine AlCrSiN - Schicht auf der Werkzeugoberfläche ausgebildet worden. Die Beschichtung ist beständig gegen Verschleiß. Sie bedeckt die Werkzeugoberfläche inkl. der konkaven Bereiche mit einer gleichmäßigen Schicht von hoher Qualität.

### Beispiel 3:

Es liegt eine Anordnung gemäß Figur 6 vor. Es wird ein Prozess durchgeführt, bei dem komplex geformte Werkzeuge beschichtet werden sollen. Die Beschichtung erfolgt mit einer AlCrN- Schicht. Zunächst werden die Werkzeuge als Substrate chemisch gereinigt, getrocknet und in der Vakuumkammer auf drehbaren Substrathaltern (Planetary) so angeordnet, dass die Werkzeuge unter ständiger Drehung in drei Achsen an dem als Kathode geschalteten Target 1 vorbei geführt werden. Nach der Evakuierung auf 10⁻³ Pa erfolgt eine Ionenreinigung mit Argonionen. Die anschließende Beschichtung erfolgt, indem als Target 1, eine Platte aus AlCr in der Zusammensetzung (70:30 at%) verwendet wird. Als Reaktivgas wird Stickstoff bei einem Druck von 1 Pa in die Vakuumkammer eingeführt. Mit einem elektrischen Entladungsstrom von 100 A an der Stromquelle 3, an die das Target 1 angeschlossen ist, wird Targetwerkstoff mit einer elektrischen Bogenentladung sukzessive verdampft. Die elektrische Spannung der Stromquelle 4, an die die erste Anode 2 angeschlossen ist, wird auf 30 V eingestellt und die elektrische Spannung an der Stromquelle 6, an die die zweite Anode 5 angeschlossen ist, auf 40 V. Während der Beschichtung werden die zu beschichtenden Werkzeuge auf einem elektrischen Potential (Bias-Spannung) von -10V gegenüber Erdpotential gehalten.

Die elektrische Bogenentladung wird so lange betrieben, bis die gewünschte Schichtdicke erreicht ist.

Im Ergebnis ist eine AlCrN - Schicht auf Oberflächen der Werkzeuge entstanden. Die Beschichtung ist beständig gegen Verschleiß. Sie bedeckt die komplex geformte Werkzeugoberflächen mit einer gleichmäßigen Schicht von hoher Qualität.

## Patentansprüche

1. Anordnung zur Beschichtung von Substratoberflächen mittels elektrischer Lichtbogenentladung in einer Vakuumkammer, bei der elektrische Bogenentladungen zwischen einem elektrisch als Kathode geschalteten Target (1), das aus einem metallischen Werkstoff gebildet ist und einer in einem Abstand zum Target (1) angeordneten Anode (2) zur Bildung eines mit metallischem Werkstoff des Targets (1) gebildeten Plasma, gezündet werden, wobei das Target (1) an eine erste elektrische Stromquelle (3) und die Anode (2) an eine zweite elektrische Stromquelle (4) angeschlossen sind, wobei sich die absoluten Beträge der an das Target (1) und der an die Anode (2) angeschlossenen elektrischen Spannungen voneinander unterscheiden
**dadurch gekennzeichnet, dass** mehrere Anoden (2, 5, 7) in einem Abstand zueinander und in Richtung auf die jeweilige zu beschichtende Substratoberfläche angeordnet sind an jeweils eine eigene elektrische Stromquelle (4, 6, 8) angeschlossen sind, wobei die Anoden (2, 5, 7) auf jeweils unterschiedliche elektrische Spannungspotentiale gelegt sind und dabei
eine Differenz des positiven elektrischen Spannungspotentials zwischen zwei nebeneinander angeordneten Anoden eingehalten ist und sich die elektrischen Spannungspotentiale in Richtung der zu beschichtenden Substratoberfläche erhöhen.

2. Anordnung nach Anspruch 1, **dadurch gekennzeichnet, dass** alle elektrischen Stromquellen (4, 6, 8) gleichzeitig eingeschaltet sind.

3. Anordnung nach Anspruch 1 oder 2, **dadurch gekennzeichnet, dass** die Anoden (2, 5, 7) ringförmig ausgebildet sind, und das Target (1) im Inneren der Ringe(s) angeordnet ist.

4. Anordnung nach Anspruch 3, dadurch ge-kennzeichnet, dass die ringförmig ausgebildeten Anoden (2, 5, 7) an ihrer Innenseite konisch ausgebildet sind, so dass sich der Innendurchmesser in Richtung der zu beschichtenden Substratoberfläche konisch erweitert.

5. Anordnung nach einem der vorhergehenden Ansprüche, **dadurch gekennzeichnet, dass** die Anoden (2, 5, 7) aus Graphit gebildet und/oder ihre Innenwand/-wände mit einer bevorzugt aus Graphit gebildeten Abdeckung (10) versehen sind.

6. Anordnung nach einem der vorhergehenden Ansprüche, **dadurch gekennzeichnet, dass** mindestens ein Reaktivgas in die Vakuumkammer einführbar ist.

7. Anordnung nach einem der vorhergehenden Ansprüche, **dadurch gekennzeichnet, dass** das Target (1) mit einer Legierung, die ausgewählt ist aus AlCr, AlTi, AlTiMg, AlTiSi, AlCrSi, AlCrY, AlCrC, CrTiSi, CrSi, CrCu, CrFeNi, CoCrFeMnNi, CoCrFeNi, CoCrFeCu,TiSi, IrPt, NiCr, NiCrCo, NiCrCoTi, NiCrCoTiAl, NbTiVZrMo, und NiV gebildet ist.

## Claims

1. An arrangement for coating substrate surfaces by means of electric arc discharge in a vacuum chamber, in which electric arc discharges are ignited between a target (1) electrically connected as a cathode, which is formed from a metallic material, and an anode (2) arranged at a distance from the target (1) to form a plasma formed with metallic material of the target (1), the target (1) being connected to a first electrical current source (3) and the anode (2) being connected to a second electrical current source (4), the absolute values of the electrical voltages connected to the target (1) and to the anode (2) differing from one another.
**characterized in that** a plurality of anodes (2, 5, 7) are arranged at a distance from one another and in the direction of the respective substrate surface to be coated and are each connected to a separate electrical current source (4, 6, 8), the anodes (2, 5, 7) each being connected to different electrical voltage potentials and therein
a difference in the positive electrical voltage potential between two anodes arranged next to each other is maintained and the electrical voltage potentials increase in the direction of the substrate surface to be coated.

2. The arrangement according to claim 1, **characterized in that** all electrical current sources (4, 6, 8) are switched on simultaneously.

3. The arrangement according to claim 1 or 2, **characterized in that** the anodes (2, 5, 7) are ring-shaped and the target (1) is arranged inside the ring(s).

4. The arrangement according to claim 3,
**characterized in that** the ring-shaped anodes (2, 5, 7) are conical on their inner side, so that the inner diameter widens conically in the direction of the substrate surface to be coated.

5. The arrangement according to one of the preceding claims, **characterized in that** the anodes (2, 5, 7) are formed from graphite and/or their inner wall(s) are provided with a cover (10) preferably formed from graphite.

6. The arrangement according to one of the preceding claims, **characterized in that** at least one reactive gas can be introduced into the vacuum chamber.

7. The arrangement according to one of the preceding claims, **characterized in that** the target (1) is coated with an alloy selected from AlCr, AlTi, AlTiMg, AlTiSi, AlCrSi, AlCrY, AlCrC, CrTiSi, CrSi, CrCu, CrFeNi, CoCrFeMnNi, CoCrFeNi, CoCrFeCu, TiSi, IrPt, NiCr, NiCrCo, NiCrCoTi, NiCrCoTiAl, NbTiVZrMo, and NiV.

## Revendications

1. Dispositif pour revêtement de surfaces de substrats au moyen d'une décharge électrique en arc dans une chambre à vide dans laquelle des décharges électriques en arc sont déclenchées entre une cible (1) connectée électriquement faisant office de cathode, formée d'un matériau métallique, et une anode (2) disposée à une certaine distance de la cible (1) pour former un plasma à partir du matériau métallique de la cible (1), la cible (1) étant connectée à une première source de courant électrique (3) et l'anode (2) étant connectée à une seconde source de courant électrique (4), les valeurs absolues des tensions électriques appliquées à la cible (1) et à l'anode (2) étant différentes l'une de l'autre.
**caractérisé en ce que** plusieurs anodes (2, 5, 7) sont disposées à une certaine distance les unes des autres et en direction de la surface de substrat respective à revêtir, et sont raccordées chacune à une source de courant électrique propre (4, 6, 8), les anodes (2, 5, 7) étant placées à des potentiels de tension électrique respectivement différents et à cet égard
une différence de potentiel de tension électrique positif est maintenue entre deux anodes disposées côte à côte et les potentiels de tension électrique augmentent en direction de la surface du substrat à revêtir.

2. Dispositif selon la revendication 1, **caractérisé en ce que** toutes les sources de courant électrique (4, 6, 8) sont activées simultanément.

3. Dispositif selon la revendication 1 ou 2, **caractérisé en ce que** les anodes (2, 5, 7) sont en forme d'anneau et la cible (1) est disposée à l'intérieur du ou des anneaux.

4. Dispositif selon la revendication 3,
**caractérisé en ce que** les anodes (2, 5, 7) en forme d'anneau sont coniques sur leur face interne, de sorte que le diamètre intérieur s'élargit de manière conique en direction de la surface du substrat à revêtir.

5. Dispositif selon l'une des revendications précédentes, **caractérisé en ce que** les anodes (2, 5, 7) sont composées de graphite et/ou leur(s) paroi(s) interne(s) est/sont pourvue(s) d'un couvercle (10) de préférence en graphite.

6. Dispositif selon l'une des revendications précédentes, **caractérisé en ce qu'**au moins un gaz réactif peut être introduit dans la chambre à vide.

7. Dispositif selon l'une des revendications précédentes, **caractérisé en ce que** la cible (1) est recouverte d'un alliage choisi parmi les alliages AICr, AlTi, AlTiMg, AlTiSi, AlCrSi, AlCrY, AlCrC, CrTiSi, CrSi, CrCu, CrFeNi, CoCrFeMnNi, CoCrFeNi, CoCrFeCu, TiSi, IrPt, NiCr, NiCrCo, NiCrCoTi, NiCrCoTiAl, NbTiVZrMo et NiV.
